# EUROPÄISCHE PATENTSCHRIFT

(11) **EP 2 203 977 B1**
(45) Veröffentlichungstag und Bekanntmachung des Hinweises auf die Patenterteilung: **30.03.2011**
(21) Anmeldenummer: 08839222.0
(22) Anmeldetag: 16.10.2008
(51) Int. Cl.: H03K 17/082, H03K 17/16

(54) **SCHALTUNGSANORDNUNG ZUM SCHUTZ EINES SCHALTELEMENTS MIT ÜBERSTROM UND ÜBERTEMPERATURDETEKTION**
CIRCUIT CONFIGURATION FOR PROTECTING A CIRCUIT ELEMENT HAVING OVERCURRENT AND OVERTEMPERATURE DETECTION
CIRCUIT DE PROTECTION D'UN ÉLÉMENT DE COMMUTATION AVEC DÉTECTION DE SURINTENSITÉ DE COURANT ET D'ÉLÉVATION DE TEMPÉRATURE

(30) Priorität: 17.10.2007 DE 102007049789
(43) Veröffentlichungstag der Anmeldung: 07.07.2010
(73) Patentinhaber: Continental Automotive GmbH, 30165 Hannover (DE)
(72) Erfinder: MARTIN, Edmund, 65824 Schwalbach (DE)
(86) Internationale Anmeldenummer: PCT/EP2008/063932
(87) Internationale Veröffentlichungsnummer: WO 2009/050224

(56) Entgegenhaltungen:
- DE-C1- 3 302 864
- FR-A- 2 843 245
- US-A- 4 703 390
- US-A- 4 937 697

## Beschreibung

Die Erfindung betrifft eine Schaltungsanordnung, die insbesondere im Zusammenhang mit einem Transistorschalter eingesetzt werden kann, der zum Steuern einer Lastvorrichtung vorgesehen ist. Derartige Lastvorrichtungen können beispielsweise Lampen sein, so insbesondere Lampen, die in Kraftfahrzeugen eingesetzt werden. In diesem Zusammenhang ist es eine Herausforderung, über eine lange Betriebszeitdauer einen einwandfreien Betrieb des Transistorschalters zu gewährleisten und so die Notwendigkeit von Reparaturen gering zu halten.

Eine Schaltungsanordnung nach dem Oberbegriff des Anspruchs 1 ist aus der US 4,937,697 A1 bekannt.

Die Aufgabe, die der Erfindung zugrunde liegt, ist es, eine Schaltungsanordnung zu schaffen, die einen zuverlässigen Betrieb eines Transistorschalters ermöglicht. Die Aufgabe wird gelöst durch die Merkmale des unabhängigen Patentanspruchs. Vorteilhafte Ausgestaltungen der Erfindung sind in den Unteransprüchen gekennzeichnet.

Erfindungsgemäß ist ein erster Komparator zum Vergleichen eines mittels eines tiefpassgefilterten Ausgangssignals der Erfassungseinheit mit einem vorgegebenen ersten Schwellenwert und zum Initiieren eines Ausschaltvorgangs des Transistorschalters abhängig von dem Ausgang des Vergleichs in der Schaltungsanordnung ausgebildet und zwar zusammen mit dem Tiefpass in dem anwendungsspezifischen integrierten Schaltkreis. So ist, insbesondere durch eine geeignete Parametrierung des Tiefpasses und geeignete Vorgabe des ersten Schwellenwertes, ein besonders schnelles Erkennen eines Laststroms möglich, der in seinem Verlauf auf vorgegebene Weise höher ist als derjenige, der bei Vorhandensein einer vorgegebenen Lastvorrichtung zu erwarten ist und zwar beispielsweise zeitnah zu dem Einschaltvorgang des Transistorschalters und hierbei insbesondere ein Stromverlauf, der sich durch die Charakteristik von Kaltleitern ergibt, mit einer einhergehenden hohen Strombelastung zeitnah zu dem Einschaltvorgang, die mit zunehmender Erwärmung der Lampe.abklingt.

Eine sehr zeitnahe Reaktion auf einen derartigen Laststrom, der in seinem Verlauf auf vorgegebene Weise höher ist, als derjenige, der bei Vorhandensein der vorgegebenen Lastvorrichtung zu erwarten ist, ist so möglich.

Weiterhin umfasst erfindungsgemäß der Tiefpass eine eine Zeitkonstante beeinflussende Zeitkonstanteneinheit, die ausgebildet ist, die Zeitkonstante abhängig von dem Ausgangssignal der Erfassungseinheit zu verändern. Auf diese Weise können Spitzenbelastungen für den Transistorschalter besonders zeitnah erkannt werden und es kann eine entsprechende zeitnahe Reaktion darauf erfolgen.

In einer Ausgestaltung ist das Eingangssignal so von dem Transistorschalter zugeführt, dass auf zusätzliche Bauteile, wie z.B. einen Messwiderstand, verzichtet werden kann.

Gemäß einer vorteilhaften Ausgestaltung weist die Schaltungsanordnung einen zweiten Komparator zum Vergleichen des Ausgangssignals der Erfassungseinheit mit einem vorgegebenen zweiten Schwellenwert und zum Initiieren eines Ausschaltvorgangs des Transistorschalters abhängig von dem Ausgang des Vergleichs. Der zweite Komparator ist in dem anwendungsspezifischen integrierten Schaltkreis ausgebildet. Dies ermöglicht ein besonders schnelles Erkennen eines zu dem zweiten Schwellenwert ein korrespondierenden Laststroms und so eine sehr zeitnahe Reaktion des Initiierens des Ausschaltvorgangs des Transistorschalters.

Besonders vorteilhaft ist es, wenn die Zeitkonstanteneinheit eine Parallelschaltung eines ersten elektrischen Widerstandes einerseits und eines zweiten elektrischen Widerstandes und einer Zener-Diode andererseits umfasst. Auf diese Weise kann die Zeitkonstanteneinheit besonders einfach realisiert werden.

Gemäß einer weiteren vorteilhaften Ausgestaltung ist eine Temperaturerfassungseinheit zum Erfassen einer Umgebungstemperatur und zum Initiieren des Ausschaltvorgangs des Transistorschalters abhängig von einem Überschreiten eines vorgegebenen dritten Schwellenwertes durch die umfasste Umgebungstemperatur in dem anwendungsspezifischen integrierten Schaltkreis ausgebildet. Auf diese Weise kann mit besonders hoher Sicherheit ein Betrieb des Transistorschalters vermieden werden, bei Umgebungstemperaturen, die kritisch sind für die Lebensdauer des Transistorschalters in dem eingeschalteten Zustand und zwar insbesondere bei geeigneter Vorgabe des dritten Schwellenwertes.

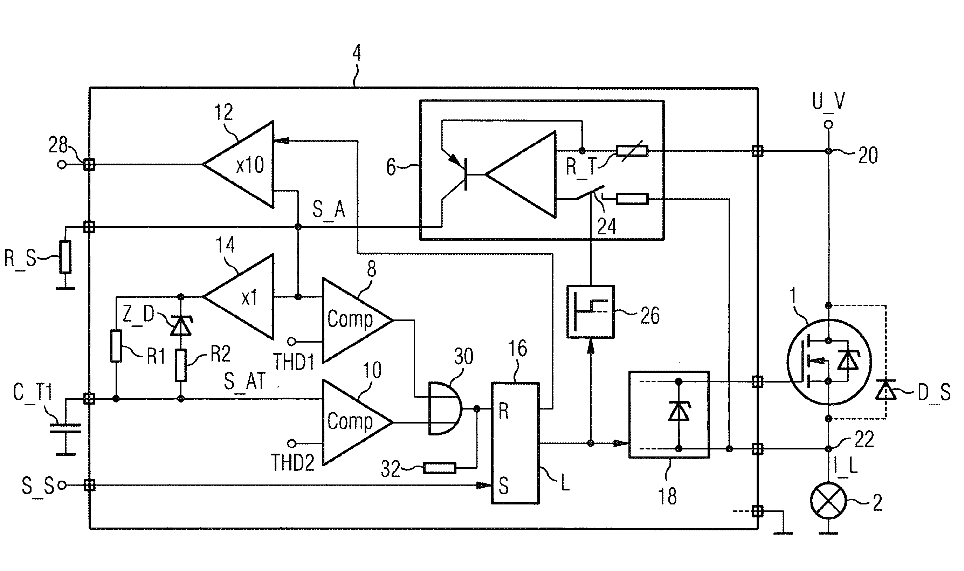

Ausführungsbeispiele der Erfindung sind im Folgenden anhand der schematischen Zeichnungen näher erläutert. Die Figur zeigt eine Schaltungsanordnung, einen Transistorschalter 1 und eine Lastvorrichtung 2.

Der Transistorschalter 1 ist so in Serie zu einer Lastvorrichtung 2 angeordnet, dass abhängig von dem Schaltzustand des Transistorschalters 1 ein an einem Lasteingang anliegendes Versorgungsspannungsspotential U_V im Wesentlichen auch an einem Lastausgang des Transistorschalters 1 anliegt oder entsprechend nicht anliegt. Das Versorgungsspannungspotential U_V kann beispielsweise 28 V oder 12 V oder auch ein beliebiges anderes Potential sein. Der Transistorschalter 1 ist beispielsweise als Feldeffekttransistor ausgebildet und zwar bevorzugt als Leistungs-Feldeffekttransistor. Über den Lastausgang des Transistorschalters 1 ist dieser elektrisch leitend mit der Lastvorrichtung 2 gekoppelt. Abhängig von dem Schaltzustand des Transistorschalters 1 wird somit ein Laststrom I_L durch die Lastvorrichtung 2 vorgegeben. Die Lastvorrichtung 2 kann beispielsweise eine Lampe sein. Die Lampe kann jede beliebige dem Fachmann bekannte Art von Lampe sein, so kann sie beispielsweise eine Halogenlampe sein oder eine konventionelle Glühlampe oder auch Leuchtdioden umfassen. Insbesondere bei Glühlampen oder Halogenlampen finden Glühwendeln Einsatz, die elektrische Kaltleiter bilden. Dies hat zur Folge, dass nach einem Einschaltvorgang des Transistorschalters 1 zunächst ein sehr hoher Laststrom I_L durch die Lastvorrichtung 2 strömt, der dann mit zunehmender Erhitzung der Glühwendel abnimmt. Dem Transistorschalter 1 ist zum Steuern und/oder Überwachen des Transistorschalters 1 ein anwendungsspezifischer integrierter Schaltkreis 4 zugeordnet, der auch als ASIC bezeichnet werden kann. Der anwendungsspezifische integrierte Schaltkreis 4 umfasst eine Erfassungseinheit 6, einen ersten Komparator 10, einen zweiten Komparator 8, einen ersten Verstärker 12, einen zweiten Verstärker 14, einen Tiefpass, einen Latch 16 und eine Ladungspumpe 18. Der anwendungsspezifische integrierte Schaltkreis 4 kann jedoch auch eine beliebige Untermenge der genannten Einheiten umfassen.

Die Erfassungseinheit 6 ist eingangsseitig über Abgriffspunkte 20, 22 zum Abgreifen eines Spannungsabfalls zwischen dem Lasteingang und dem Lastausgang des Transistorschalters 1 gekoppelt. Im Falle eines Feldeffekttransistors ist dies bevorzugt die Drain-Source-Spannung. Die an den Abgriffspunkten 20, 22 abgegriffene Spannung ist für den durchgeschalteten Zustand des Transistorschalters unter Vernachlässigung von Temperatureffekten des Durchlasswiderstandes des Transistorschalters repräsentativ für dessen Laststrom I_L. Zur Kompensation eben dieser Temperatureinflüsse umfasst die Erfassungseinheit 6 eine Temperaturkompensationseinheit, die bevorzugt einen temperaturabhängigen Widerstand R_T aufweist, der so ausgebildet und dimensioniert ist, dass er entsprechende Temperatureffekte des Durchlasswiderstandes in dem Lastzweig des Transistorschalters 1 weitgehend kompensiert.

Darüber hinaus weist die Erfassungseinheit 6 auch eine Verzögerungseinheit auf, die ausgebildet ist zum Verzögern des Erfassens des Eingangssignals, bis eine vorgegebene Einschaltdauer bezogen auf einen Einschaltvorgang des Transistorschalters 1 abgelaufen ist. Dazu weist die Verzögerungseinheit bevorzugt ein Verzögerungsglied 26 auf, das ein für das Steuern eines Einschaltvorgangs verantwortliches Signal, um die vorgegebene Verzögerungszeitdauer verzögert, in ein Steuersignal zum Durchschalten eines Verzögerungsschalters 24 umsetzt und so ein Erfassen des Eingangssignals der Erfassungseinheit 6 entsprechend verzögert bezogen auf den jeweiligen Einschaltvorgang des Transistorschalters 1. Auf diese Weise kann einfach sichergestellt werden, dass während des Einschaltvorgangs gegebenenfalls auftretende hohe Spannungsabfälle innerhalb des Lastzweiges des Transistorschalters 1 nicht durch die Erfassungseinheit 6 in ein entsprechendes Ausgangssignal S_A umgeformt werden, das in diesem Fall dann nicht repräsentativ wäre für den Laststrom I_L in dem Transistorschalter, da dieser innerhalb dieses Zeitintervalls auch nicht oder nicht vollständig durchgeschaltet wäre.

Die Temperaturkompensationseinheit kann einfach und kostengünstig in dem anwendungsspezifischen integrierten Schaltkreis 4 angeordnet sein. Es hat sich hier gezeigt, dass eine ausreichend gute Temperaturkompensation bereits erreicht werden kann, wenn der anwendungsspezifische integrierte Schaltkreis benachbart zu dem Transistorschalter 1 platziert ist. So hat es sich insbesondere gezeigt, dass gegebenenfalls ein hoher Laststrom I_L zeitnah zu dem Einschaltvorgang des Transistorschalters 1 hervorgerufen durch den gegebenenfalls geringen Widerstand des Kaltleiters der Lastvorrichtung 2 nur sehr kleine und daher vernachlässigbare Temperaturfehler erzeugt. Überlast- oder Kurzschlussvorgänge erhöhen die Temperatur des Transistorschalters 1 dagegen relativ schnell. In einem solchen Fall ist jedoch ein schnelles Abschalten des Transistorschalters 1 ohnehin erstrebenswert und insofern ein exaktes Erfassen des Laststroms I_L nicht unbedingt notwendig. Vielmehr zeigt sich hier der Effekt, dass durch eine gegebenenfalls verringerte Temperaturkompensation in diesem Fehlerfall durch die Erfassungseinheit 6 ein vermeintlich höherer Laststrom I_L als tatsächlich vorhanden sensiert wird, was dann letztlich, wie weiter unten noch näher erläutert, ein Abschalten des Transistorschalters 1 beschleunigt.

Durch das Vorsehen des Widerstandes R_T kann einfach die Verstärkung der Erfassungseinheit 6 temperaturabhängig ausgelegt sein und so ein Temperaturgang des Durchlasswiderstandes des Transistorschalters 1 gut kompensiert werden.

Die Erfassungseinheit 6 umfasst bevorzugt auch einen Pegelumsetzer, der wiederum einen Differenzverstärker umfassen kann. Ausgangsseitig der Erfassungseinheit wird von dieser ein Ausgangssignal S_A der Erfassungseinheit 6 bereitgestellt, das repräsentativ ist für den Laststrom I_L des Transistorschalters 1.

Durch einen ausgangsseitig mit der Erfassungseinheit gekoppelten Widerstand R_S kann die Verstärkung der Erfassungseinheit 6 angepasst werden und somit ein geeigneter Signalwertbereich des Ausgangssignals S_A der Erfassungseinheit 6 eingestellt werden und so auch insbesondere eine Anpassung an den jeweils eingesetzten Transistorschalter 1 vorgenommen werden.

Bevorzugt ist der Widerstand R_S extern zu dem anwendungsspezifischen integrierten Schaltkreis 4 angeordnet und kann so einfach je nach eingesetztem Transistorschalter 1 unterschiedlich dimensioniert werden bei ansonsten unveränderten anwendungsspezifischen integrierten Schaltkreis 4.

Der erste Verstärker 12 ist vorgesehen zum Verstärken des Ausgangssignals S_A der Erfassungseinheit und ist ausgangsseitig mit einem Signalausgang 28 des anwendungsspezifischen integrierten Schaltkreises 4 gekoppelt. Der Signalausgang 28 kann eine Schnittstelle zu einer übergeordneten Steuervorrichtung oder Auswertevorrichtung bilden.

Das Ausgangssignals S_A der Erfassungseinheit 6 ist ferner dem zweiten Komparator 8 eingangsseitig zugeführt, an dessen weiteren Eingang ein vorgegebener zweiter Schwellenwert THD1 anliegt, der beispielsweise 4 V betragen kann. Der zweite Komparator 8 ist ausgebildet zum Vergleichen des Ausgangssignals S_A der Erfassungseinheit 6 mit dem vorgegebenen zweiten Schwellenwert THD1 und zum Initiieren eines Ausschaltvorgangs des Transistorschalters 1 abhängig von dem Ausgang des Vergleichs. Dazu kann er beispielsweise dann, wenn das Ausgangssignal S_A den zweiten Schwellenwert THD1 überschreitet, einen hohen Pegel ausgangsseitig bereitstellen. Ausgangsseitig ist der Komparator elektrisch leitend über ein ODER-Glied 30 mit einem Rücksetzeingang R des Latches 16 gekoppelt. Im Falle einer positiven Logik wird somit das Latch 16 über den Rücksetzeingang R dann beispielsweise flankengesteuert bis zum nächsten Wechsel eines auf seinen Setzeingang einwirkenden Steuersignals S_S gesperrt und damit ein Ausschaltvorgang des Schalttransistors 1 initiiert.

Das Latch 16 ist bevorzugt über eine Ladungspumpe 18 zum Steuern eines Steuereingangs des Schalttransistors 1 mit diesem koppelbar und kann so durch entsprechendes Bereitstellen entsprechender Pegel an seinem Ausgang einen Einschaltvorgang und auch einen Ausschaltvorgang bei dem ersten Transistorschalter 1 initiieren. Im Falle eines als MOSFET ausgebildeten Transistorschalters 1 ist der Steuereingang bevorzugt dessen Gate.

Das Ausgangssignal S_A der Erfassungseinheit 6 ist darüber hinaus dem zweiten Verstärker 14 zugeführt, der ausgangsseitig mit einem Tiefpass gekoppelt ist. Der Tiefpass umfasst eine Zeitkonstanteneinheit, die bevorzugt in einem ersten Zweig einen ersten elektrischen Widerstand R_1 umfasst und in einem zweiten elektrisch parallel ausgebildeten Zweig einen zweiten elektrischen Widerstand R_2 und in Serie dazu eine Zener-Diode Z_D umfasst. Darüber hinaus ist dem Tiefpass eine Kapazität C_T1 zugeordnet, die beispielsweise durch externe Beschaltung des anwendungsspezifischen integrierten Schaltkreises 4 durch einen Kondensator realisiert sein kann. Durch ein externes Vorsehen der Kapazität C_T1 kann einfach die Schaltungsanordnung an jeweils unterschiedliche Charakteristiken des Transistorschalters 1 und/oder der Lastvorrichtung 2 angepasst werden.

Durch das Parallelschalten des ersten elektrischen Widerstandes R1 einerseits und andererseits des zweiten elektrischen Widerstands R2 und der Zener-Diode Z_D ist die Zeitkonstante des Tiefpasses abhängig von dem Ausgangssignal S_A der Erfassungseinheit 6 einstellbar und zwar abhängig von den Werten des Ausgangssignals S_A und so beispielsweise abhängig von seiner Amplitude. Insofern kann beispielsweise bei einer hohen Signalamplitude eine deutlich geringere Zeitkonstante eingestellt werden. Die Zener-Diode Z_D ist beispielsweise so ausgebildet, dass sie den bei ihr auftretenden Spannungsabfall auf maximal 2 V begrenzt. Der erste Widerstand R1 kann beispielsweise einen Widerstandswert von 200 KΩ aufweisen und der zweite Widerstand R_2 beispielsweise einen Widerstandswert von 30 KΩ aufweisen.

Ausgangsseitig des Tiefpasses wird ein gefiltertes Ausgangssignal S_AT der Erfassungseinheit bereitgestellt und dem ersten Komparator 10 eingangsseitig zur Verfügung gestellt. An dem weiteren Eingang des ersten Komparators 10 ist dieser mit einem vorgegebenen ersten Schwellenwert THD2 beaufschlagt, der beispielsweise 500 mV betragen kann. Der erste Komparator 10 ist ausgebildet zum Vergleichen des mittels des Tiefpasses gefilterten Ausgangssignals S_AT der Erfassungseinheit 6 mit dem vorgegebenen ersten Schwellenwert und zum Initiieren eines Ausschaltvorgangs des Transistorschalters abhängig von dem Ausgang des Vergleichs. Ausgangsseitig ist auch der erste Komparator 10 über das ODER-Glied 30 mit dem Rücksetzeingang R des Latches 16 gekoppelt. Durch das geeignete Dimensionieren des Tiefpasses im Zusammenwirken mit dem geeigneten Dimensionieren des ersten Schwellenwertes THD2 kann so besonders schnell ein Laststrom I_L erkannt werden, der in seinem Verlauf auf vorgegebene Weise höher ist als derjenige, der bei Vorhandensein einer erwartenden Charakteristik der Lastvorrichtung 2 zu erwarten ist.

Darüber hinaus kann auch eine Temperaturerfassungseinheit 32 in dem anwendungsspezifischen integrierten Schaltkreis 4 ausgebildet sein, die ausgebildet ist zum Erfassen der Umgebungstemperatur des anwendungsspezifischen integrierten Schaltkreises 4. Sie ist ferner darüber hinaus ausgebildet bei einem Überschreiten eines dritten Schwellenwertes durch die erfasste Umgebungstemperatur den Ausschaltvorgang des Transistorschalters 1 zu initiieren. Zu diesem Zweck ist die Temperaturerfassungseinheit 32 bevorzugt ebenso mit dem Rücksetzeingang des Latches 16 gekoppelt.

Bei aktiviertem Rücksetzeingang R des Latches 16 wird bevorzugt an dem Signalausgang 28 eine entsprechende Signalisierung durchgeführt, was beispielsweise durch einen im Vergleich zu dem maximal durch das Ausgangssignal S_A der Erfassungseinheit 6 erreichbaren Signalwert erhöhten Signalwert realisiert sein kann. Auf diese Weise kann auch der zugeordneten Steuer- oder Auswerteeinheit signalisiert werden, wenn das Latch 16 sich in seinem rückgesetzten Zustand befindet.

Durch das Vorsehen des Tiefpasses im Zusammenwirken mit dem ersten Komparator 10, realisiert auf dem anwendungsspezifischen integrierten Schaltkreis 4, können im Kurzschlussfall auch vorhandene Schmelzsicherungen vor dem Ansprechen geschützt werden, die sich insbesondere in einer Zuleitung befinden, die das Versorgungsspannungspotential U_V zuführt.

Durch die Ausgestaltung des anwendungsspezifischen integrierten Schaltkreises 4 kann ein starkes Aufheizen des Transistorschalters auch im Fehlerfall weitgehend vermieden werden, in dem Sinne, dass der Transistorschalter 1 nicht bis zu einem kritischen Temperaturbereich aufgeheizt wird und somit kann einfach gewährleistet werden, dass trotz des möglichen Auftretens vieler Kurzschlüsse der Transistorschalter 1 eine lange Lebensdauer aufweist.

Die Substratdiode des Transistorschalters 1, insbesondere im Falle seiner Ausbildung als Feldeffekttransistor, kann zur Abkommutierung des Laststroms I_L verwendet werden im Rahmen eines Ausschaltvorgangs des Transistorschalters 1. Längere Leitungen, wie sie beispielsweise bei Lkws üblich sind, stellen eine gegebenenfalls zu berücksichtigende Induktivität dar. Wenn die Belastbarkeit des Transistorschalters 1 nicht ausreicht, kann gegebenenfalls zusätzlich eine zusätzliche Diode D_S parallel zu dem Lasteingang und Lastausgang des Transistorschalters 1 geschaltet werden, also insbesondere parallel zu der Drain-Source-Strecke. Die Diode D_S kann auch als Supressordiode bezeichnet werden.

## Patentansprüche

1. Schaltungsanordnung mit einer Erfassungseinheit (6), die ausgebildet ist zum Erzeugen eines Ausgangssignals (S_A), das repräsentativ ist für einen Laststrom (I_L) eines Transistorschalters (1), und zwar abhängig von einem Eingangssignal, das repräsentativ ist für den Laststrom (I_L) des Transistorschalters (1), wobei die Erfassungseinheit (6) eine Temperaturkompensationseinheit, die ausgebildet ist zum Berücksichtigen der Temperatur des Transistorschalters (1), und eine Verzögerungseinheit umfasst, die ausgebildet ist zum Verzögern des Erfassens des Eingangssignals, bis eine vorgegebene Einschaltzeitdauer bezogen auf einen Einschaltvorgang des Transistorschalters (1) abgelaufen ist, wobei die Erfassungseinheit (6) in einem anwendungsspezifischen integrierten Schaltkreis (4) ausgebildet ist, **gekennzeichnet durch** einen ersten Komparator (10), der zum Vergleichen eines mittels eines Tiefpasses gefilterten Ausgangssignals (S_AT) der Erfassungseinheit (6) mit einem vorgegebenen ersten Schwellenwert (THD2) und zum Initiieren eines Ausschaltvorgangs des Transistorschalters (1) abhängig von dem Ausgang des Vergleichs in dem anwendungsspezifischen integrierten Schaltkreis (4) mit dem Tiefpass ausgebildet ist, wobei der Tiefpass eine eine Zeitkonstante beeinflussende Zeitkonstanteneinheit umfasst, die ausgebildet ist, die Zeitkonstante abhängig von dem Ausgangssignal (S_A) der Erfassungseinheit (6) zu verändern.

2. Schaltungsanordnung nach Anspruch 1, bei der ein zweiter Komparator (8) zum Vergleichen des Ausgangssignals (S A) der Erfassungseinheit (6) mit einem vorgegebenen zweiten Schwellenwert (THD1) und zum Initiieren eines Ausschaltvorgangs des Transistorschalters (1) abhängig von dem Ausgang des Vergleichs in dem anwendungsspezifischen integrierten Schaltkreis (4) ausgebildet ist.

3. Schaltungsanordnung nach einem der vorstehenden Ansprüche, bei der die Zeitkonstanteneinheit eine Parallelschaltung eines ersten elektrischen Widerstands (R_1) einerseits und eines zweiten elektrischen Widerstands (R_2) und einer Zener-Diode (Z_D) andererseits umfasst.

4. Schaltungsanordnung nach einem der vorstehenden Ansprüche, bei der eine Temperaturerfassungseinheit (32) zum Erfassen einer Umgebungstemperatur und zum Initiieren des Ausschaltvorgangs des Transistorschalters (1) abhängig von einem Überschreiten eines vorgegebenen dritten Schwellenwertes durch die erfasste Umgebungstemperatur in dem anwendungsspezifischen integrierten Schaltkreis (4) ausgebildet ist.

5. Schaltungsanordnung nach einem der vorstehenden Ansprüche, bei der eine Ladungspumpe (18) zum Ansteuern des Transistorschalters (1) in dem anwendungsspezifischen integrierten Schaltkreis (4) ausgebildet ist.

## Claims

1. Circuit arrangement comprising a detection unit (6) designed for generating an output signal (S_A) representative of a load current (I_L) of a transistor switch (1), to be precise depending on an input signal representative of the load current (I_L) of the transistor switch (1), wherein the detection unit (6) comprises a temperature compensation unit designed to take account of the temperature of the transistor switch (1), and a delay unit designed to delay the detection of the input signal until a predetermined switch-on time period relative to a switch-on process of the transistor switch (1) has elapsed, wherein the detection unit (6) is embodied in an application-specific integrated circuit (4), **characterized by** a first comparator (10) designed for comparing an output signal (S_AT) of the detection unit (6), said output signal being filtered by means of a low-pass filter, with a predetermined first threshold value (THD2) and for initiating a switch-off process of the transistor switch (1) depending on the outcome of the comparison is embodied in the application-specific integrated circuit (4) with the low-pass filter, wherein the low-pass filter comprises a time constant unit, which influences a time constant and which is designed to alter the time constant depending on the output signal (S_A) of the detection unit (6).

2. The circuit arrangement as claimed in claim 1, wherein a second comparator (8) designed for comparing the output signal (S_A) of the detection unit (6) with a predetermined second threshold value (THD1) and for initiating a switch-off process of the transistor switch (1) depending on the outcome of the comparison is embodied in the application-specific integrated circuit (4).

3. The circuit arrangement as claimed in any of the preceding claims, wherein the time constant unit comprises a parallel circuit formed by, firstly, a first electrical resistor (R_1) and, secondly, a second electrical resistor (R_2) and a zener diode (Z_D).

4. The circuit arrangement as claimed in any of the preceding claims, wherein a temperature detection unit (32) designed for detecting an ambient temperature and for initiating the switch-off process of the transistor switch (1) depending on a predetermined third threshold value being exceeded by the detected ambient temperature is embodied in the application-specific integrated circuit (4).

5. The circuit arrangement as claimed in any of the preceding claims, wherein a charge pump (18) designed for driving the transistor switch (1) is embodied in the application-specific integrated circuit (4).

## Revendications

1. Circuit comportant une unité de détection (6), laquelle est conçue pour générer un signal de sortie (S_A) qui est représentatif pour un courant sous charge (I_L) d'un commutateur à transistors (1), et, ceci, en fonction d'un signal d'entrée, qui est représentatif pour le courant sous charge (I_L) du commutateur à transistors (1), où l'unité de détection (6) comprend une unité à compensation de température, laquelle est conçue pour tenir compte de la température du commutateur à transistors (1), et une unité de temporisation, laquelle est conçue pour temporiser la détection du signal d'entrée jusqu'à ce qu'un retard de commutation donné soit écoulé par rapport à un processus de commutation du commutateur à transistors (1), l'unité de détection (6) étant ménagée dans un circuit intégré (4) spécifique à l'application, **caractérisé par le fait qu'**un premier comparateur (10) qui est conçu pour comparer un signal de sortie (S_AT) de l'unité de détection (6) filtré au moyen d'un passe-bas à une première valeur seuil (THD2) donnée et pour initier un processus de déconnexion du commutateur à transistors (1) en fonction du résultat de la comparaison dans le circuit intégré spécifique à l'application avec le passe-bas, le passe-bas comprenant une unité de temporisation commandant une constante de temps, laquelle unité de temporisation est conçue pour modifier la constante de temps en fonction du signal de sortie (S_A) de l'unité de détection (6).

2. Circuit selon la revendication 1, dans lequel il est ménagé un deuxième comparateur (8) pour comparer le signal de sortie (S_A) de l'unité de détection (6) à une deuxième valeur seuil (THD1) donnée et pour initier un processus de déconnexion du commutateur à transistors (1) en fonction du résultat de la comparaison dans le circuit intégré (4) spécifique à l'application.

3. Circuit selon l'une des revendications précédentes, dans lequel l'unité de temporisation comprend un circuit en parallèle, d'une part, avec une première résistance électrique (R_1) et, d'autre part, avec une deuxième résistance électrique (R_2) et une diode de Zener (Z_D).

4. Circuit selon l'une des revendications précédentes, dans lequel il est ménagé une unité de détection de la température (32) pour détecter une température ambiante et pour initier le processus de déconnexion du commutateur à transistors (1) en fonction d'un dépassement d'une troisième valeur seuil donnée par la température ambiante détectée dans le circuit intégré (4) spécifique à l'application.

5. Circuit selon l'une des revendications précédentes, dans lequel il est ménagé une pompe de charge (18) destinée à exciter le commutateur à transistors (1) dans le circuit intégré (4) spécifique à l'application.
